# FASCICULE DE BREVET EUROPEEN

(11) **EP 1 160 937 B1**
(45) Date de publication et mention de la délivrance du brevet: **06.12.2006**
(21) Numéro de dépôt: 01401134.0
(22) Date de dépôt: 03.05.2001
(51) Int. Cl.: H01R 43/02, H01R 4/18

(54) **Elément de raccordement électrique soudable avec dépôt de soudure**
Elektrisches lötbares Verbindungselement mit Lötstelle
Electrical solderable connection element with solder deposition

(30) Priorité: 02.06.2000 DE 10027582; 20.09.2000 DE 10046489
(43) Date de publication de la demande: 05.12.2001
(73) Titulaire: SAINT-GOBAIN GLASS FRANCE, 92400 Courbevoie (FR)
(72) Inventeur: Reul, Bernhard, 52134 Herzogenrath (DE)
(74) Mandataire: Muller, René

(56) Documents cités:
- EP-A- 0 651 463
- DE-C- 19 536 131
- PATENT ABSTRACTS OF JAPAN vol. 1998, no. 11, 30 septembre 1998 (1998-09-30) & JP 10 162885 A (JAPAN AVIATION ELECTRON), 19 juin 1998 (1998-06-19)

## Description

L'invention se rapporte à un élément de raccordement électrique soudable présentant les caractéristiques du préambule de la revendication 1.

Par le document DE-C1-195 36 131 on connaît un élément de raccordement soudable pour des vitres d'antenne, dans lequel plusieurs faces de contact libres et les pistes conductrices associées, isolées les unes par rapport aux autres, sont rassemblées sur une feuille de support non conductrice, résistant à la chaleur, une couche de feuille supérieure étant étendue au-dessus des faces de contact, respectivement des points de soudage. Les extrémités de conducteurs, respectivement les faces de contact libres, à souder sont pourvues de dépôts de soudure soudés sur leur côté inférieur ou de raccordement. Ceux-ci sont à nouveau fondus par apport de chaleur en place pour la réalisation de l'assemblage soudé proprement dit, et ils sont assemblés durablement à une face de raccordement associée par pressage sur celle-ci. Il n'est pas prévu ici de pièce d'écartement destinée à assurer une épaisseur reproductible de la couche de soudure. On utilise actuellement un système accordé à grand frais de quantité de soudure finement dosée et d'outils et de procédés de soudage accordés avec précision, pour que la soudure se forme avec une épaisseur et une répartition superficielle uniformes suffisantes lors du pressage après la fusion.

Lors du soudage de tels éléments de raccordement dans la fabrication industrielle en grande série, on ne dispose pour chaque opération de soudage que de quelques secondes, pendant lesquelles la chaleur nécessaire doit être transmise à travers la feuille de support jusqu'aux faces de contact pré-étamées. Pour optimiser le transfert de chaleur en présence de la forte atténuation de la température, il convient d'assurer un apport de chaleur aussi étendu que possible au moyen d'outils particuliers. De même, la température de l'outil doit être nettement plus élevée que la température de fusion de la soudure. C'est pour cette raison à nouveau que la feuille de support doit être constituée d'une matière résistant à la chaleur (la plupart du temps polyimide, kapton), très coûteuse par comparaison avec d'autres matières plastiques, bien que sa résistance à la chaleur ne soit réellement nécessaire que dans une petite fraction de sa surface totale.

Un autre problème réside dans la sécurité du contact, qui ne peut être contrôlée qu'à grands frais après l'exécution de la soudure, par exemple par examen aux rayons X.

Dans l'état de la technique, la zone de contact est pourvue, sur son côté tourné vers la plage de raccordement correspondante sur la vitre, d'au moins une bande adhésive étroite, qui s'étend transversalement en ligne droite jusqu'aux pistes conductrices avec une largeur relativement faible. Ainsi, l'élément de raccordement peut être positionné et fixé provisoirement sur la vitre de fenêtre. La bande adhésive sert par ailleurs à soulager la traction sur la zone de contact proprement dite; au besoin, elle peut aussi entourer complètement celle-ci en anneau et la protéger ainsi très largement contre des influences ambiantes (humidité, encrassement).

On connaît par le document DE-C2-43 04 788 un composant stratifié préfabriqué constitué d'une mince bande métallique et d'une gaine isolante composée de minces couches de feuilles de plastique qui entoure celle-ci. Cet élément de raccordement aussi appelé conducteur plat est pourvu localement de percées coaxiales dans les deux couches de la gaine isolante et de la couche métallique, qui forment une fenêtre de contact. Dans celle-ci, on peut introduire de la soudure fondue, au moyen de laquelle la bande métallique est solidement raccordée à un conducteur électrique installé par exemple sur une vitre. Cette réalisation d'une fenêtre de contact permet aussi, en servant de fenêtre d'observation, un contrôle visuel simple du point de soudage. Cet élément de raccordement peut également être collé à la surface de la vitre.

Il est enfin connu de prévoir sur de tels conducteurs plats des sertissages crimp, par exemple pour d'une part fixer de façon sûre une fiche d'extrémité ou des éléments de commutation électriques aux pistes conductrices et d'autre part la (les) raccorder électriquement à celles-ci avec une section transversale suffisante. Une pièce d'insertion métallique avec une section transversale sensiblement en forme de U et des branches aux extrémités libres dentées est posée sur la feuille. Les dents sont pressées ou enfoncées au moyen d'un outil manuel ou mécanique approprié à travers la feuille et - à la manière d'un contact à couteau - à travers la piste conductrice et ensuite latéralement rabattues, réalisant ainsi un assemblage par emboîtement mécanique et en outre électriquement conducteur. A la région précitée en forme de U plastiquement déformable sont généralement intégrées des pattes ou des barrettes de contact ou d'autres faces de soudage.

L'invention a pour objet de proposer une autre solution pour former des dépôts de soudure sur des éléments de raccordement électriques soudables du type mentionné dans l'introduction.

Conformément à l'invention, cet objectif est atteint par les caractéristiques de la revendication 1. Les caractéristiques des revendications secondaires présentent des perfectionnements avantageux de cet objet. La revendication 11 présente, à titre d'utilisation préférée d'au moins un élément de raccordement conforme à l'invention, celle pour une vitre de fenêtre, avec des perfectionnements décrits dans les revendications secondaires 12 et 13.

Si l'on dote la région du point de contact à garnir d'un dépôt de soudure d'une pièce d'insertion métallique, solidement assemblée à la feuille de support et traversant celle-ci, cette pièce forme ainsi à plusieurs égards une meilleure base pour la formation du dépôt de soudure. On ne doit par exemple plus chauffer l'élément de raccordement lui-même, respectivement sa feuille de support, que le dépôt de soudure soit réalisé suivant une première variante en soudant une quantité de soudure sur la pièce d'insertion ou qu'il soit uniquement fixé par emboîtement mécanique sur la feuille de support en même temps que la pièce d'insertion, suivant une seconde variante.

D'une façon particulièrement préférée, il convient de prévoir un contact direct, respectivement une liaison directe du dépôt de soudure avec la face de contact de l'élément de raccordement, pour éviter l'apparition de multiples résistances de transition. Il n'est pas nécessairement indispensable de mettre le métal de la pièce d'insertion directement en contact avec la piste conductrice, respectivement avec l'extrémité dénudée du câble. La face de contact est soudée directement avec la face de raccordement correspondante du composant à mettre en contact électrique, par exemple une vitre d'antenne ou une vitre chauffante.

En option subsiste cependant aussi la variante qui consiste à mettre la pièce d'insertion en contact électrique avec le conducteur respectif, tandis que le dépôt de soudure n'est lié directement qu'à la pièce d'insertion et plus tard naturellement à la face de raccordement correspondante respective. Dans un tel cas, la partie de la pièce d'insertion pourvue du dépôt de soudure forme directement la face de contact du conducteur respectif.

Le conducteur électrique peut avoir la forme d'une piste conductrice assemblée à plat à la feuille de support ou noyée dans celle-ci et/ou également d'un câble assemblé au moins mécaniquement à la feuille de support. Dans ce dernier cas, la face de contact est opportunément formée en enlevant l'isolant à l'extrémité du câble. De cette façon, plusieurs câbles amenés individuellement peuvent aussi, d'une manière particulièrement avantageuse, être maintenus dans une disposition spatiale prédéterminée par des moyens très simples sur la feuille de support de l'élément de raccordement.

Il va de soi que différentes configurations de conducteurs électriques et de leurs faces de contact peuvent aussi être combinées ou rassemblées sur une seule feuille de support. Ainsi par exemple, des conducteurs (câbles) additionnels peuvent en cas de besoin être encore disposés sur un élément de raccordement, qui est normalement équipé d'un nombre prédéterminé de pistes conductrices. Les conducteurs individuels seront en principe isolés les uns par rapport aux autres. On peut cependant aussi mettre un câble à raccorder en supplément en contact électrique en même temps avec une piste conductrice existante et avec la face de raccordement correspondante associée, si un besoin correspondant se faisait sentir.

Dans une forme de réalisation préférée, les pièces d'insertion sont, avant l'assemblage avec l'élément de raccordement, configurées en section transversale sensiblement en forme de U avec des extrémités libres des branches dentées dont les dents sont pressées ou enfoncées à travers l'élément de raccordement et ensuite rabattues latéralement par déformation plastique. Bien entendu, on peut aussi imaginer d'autres formes de pièces d'insertion. Toutefois, la forme préférée ici promet les meilleurs résultats en raison de la possibilité d'un traitement mécanisé et de son bon rapport entre le coût et l'efficacité.

A titre d'avantage supplémentaire, la pièce d'insertion permet un apport de chaleur nettement amélioré dans le dépôt de soudure lors du soudage ultérieur de la face de contact avec la face de raccordement correspondante. Du fait qu'elle traverse l'élément de raccordement, un de ses côtés reste libre après la pose de la face de contact, respectivement du dépôt de soudure, sur la base et peut être utilisé pour l'apport de chaleur au point de soudage proprement dit. Etant donné que les métaux conduisent nettement mieux la chaleur que les plastiques, il en résulte un transfert de chaleur nettement amélioré de l'outil de soudage au dépôt de soudure. Le cas échéant, on peut passer d'un apport de chaleur à plat à des fers à souder, à un laser et analogue. Le temps requis par opération de soudage est nettement raccourci. La température de l'outil peut être abaissée. En outre, on peut éventuellement utiliser comme feuille de support une matière plastique moins résistante à la chaleur et par conséquent moins coûteuse. Enfin, la charge thermique autour des points de soudage diminue.

Encore un autre avantage de la pièce d'insertion métallique est son rôle de pièce d'écartement. L'inconvénient minime d'une épaisseur accrue par rapport à la zone de contact de l'élément de raccordement à câble plat connu est avantageusement plus que compensée par le fait que la pièce d'insertion, respectivement ses dents rabattues, se maintiennent en permanence à une hauteur prédéterminée au-dessus de la face de contact. L'espace créé ici peut être comblé avec le dépôt de soudure avec une sécurité suffisante et est en même temps solidement délimité, de sorte que l'application normale pendant la fusion ne puisse plus provoquer d'expulsion latérale de la matière de soudage. On peut dès lors aussi en attendre une amélioration de la qualité des assemblages soudés. Une autre conséquence de la sécurité accrue contre une expulsion latérale de la soudure est que les distances entre des faces de contact voisines peuvent être réduites par rapport à l'état de la technique, parce que le risque de courts-circuits par la soudure expulsée est considérablement réduit.

Encore un avantage par rapport à la formation directe de dépôts de soudure sur les pistes conductrices réside dans la rigidité mécanique propre des pièces d'insertion. Si un effort est exercé sur l'élément de raccordement, les assemblages soudés réalisés avec des pièces d'insertion sont plus difficilement arrachés que ceux qui n'ont pas de pièces d'insertion, de sorte que l'on peut éventuellement se passer d'une sécurité supplémentaire par des bandes adhésives ou analogues.

De même, suivant un perfectionnement et comme dans l'état de la technique, il peut aussi être prévu des assemblages collés dans la zone de contact entre l'élément de raccordement conforme à l'invention et l'autre composant, par exemple pour protéger le point de soudage contre l'action de l'humidité ou de l'encrassement.

Malgré leur épaisseur légèrement accrue dans la zone de contact, les éléments de raccordement conformes à l'invention peuvent être utilisés non seulement sur des surfaces libres de vitres de fenêtre monolithiques, mais aussi sur des surfaces de fenêtres qui se trouvent à l'intérieur de vitres feuilletées. Les films adhésifs normalement utilisés dans les feuilletés sont toujours encore bien plus épais que les zones de contact et peuvent enrober celles-ci sans difficultés.

Bien entendu, l'application des éléments de raccordement décrits ici n'est cependant pas limitée à la mise en contact électrique de vitres de fenêtre.

Au total - et quelle que soit l'utilisation envisagée - l'équipement des éléments de raccordement avec les pièces d'insertion couplé à la formation du dépôt de soudure peut être mécanisé dans une large mesure, tout comme la fabrication de l'assemblage soudé proprement dit - en utilisant la fonction de pièce d'écartement des pièces d'insertion.

D'autres détails et avantages de l'objet de l'invention seront révélés par le dessin d'exemples préférés de réalisation et par la description détaillée qui en est donnée ci-dessous.

Dans la représentation simplifiée et fortement agrandie, la
- Fig. 1: est une vue en perspective d'une zone de contact bipolaire garnie de pièces d'insertion avec deux étapes successives de la fixation des pièces d'insertion, dans laquelle un dépôt de soudure est soudé à la pièce d'insertion elle-même; la
- Fig. 2: représente une deuxième forme de réalisation, dans laquelle le dépôt de soudure est pressé à froid sur la face de contact d'une zone de contact unipolaire, au moyen de la pièce d'insertion; la
- Fig. 3: est une représentation en coupe d'une zone de contact unipolaire soudée terminée entre l'élément de raccordement et une vitre de fenêtre pourvue d'une face de raccordement correspondante; et la
- Fig. 4: est une représentation en coupe d'une variante analogue à la Figure 3, dans laquelle le conducteur a la forme d'un câble dénudé à l'extrémité et est assemblé à la feuille de support et au dépôt de soudure au moyen de la pièce d'insertion.

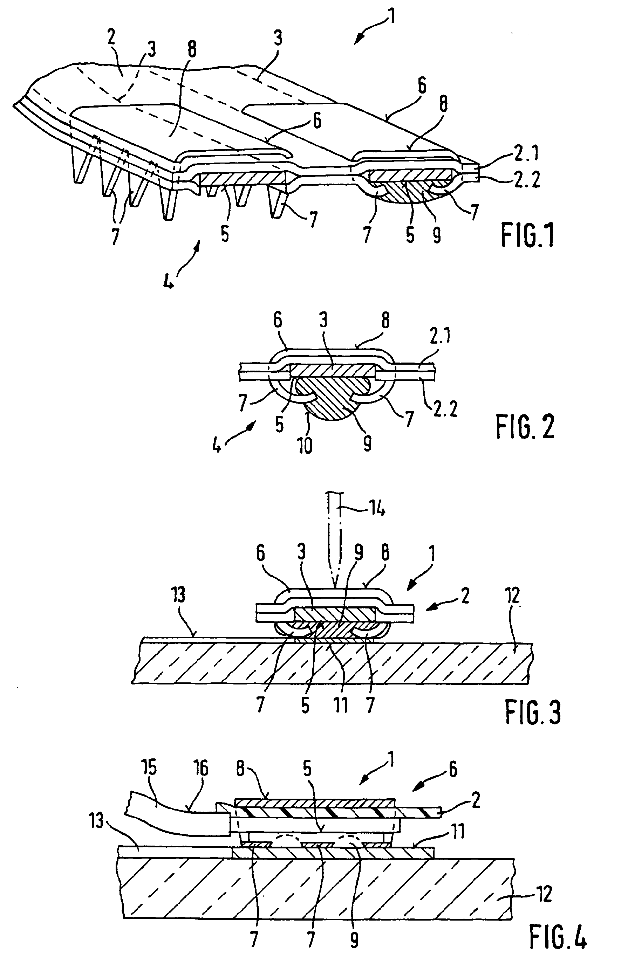

Suivant la Figure 1, un élément de raccordement 1 se compose d'une feuille de support lamellée 2 avec une couche supérieure 2.1 et une couche inférieure 2.2, entre lesquelles sont logées deux bandes métalliques parallèles constituant des pistes conductrices 3 électriquement isolées l'une par rapport à l'autre. Dans une zone de contact 4, les pistes conductrices 3 sont dénudées par l'enlèvement local de la couche inférieure 2.2 de la feuille de support, de façon à ce que l'on puisse disposer à cet endroit de faces de contact 5. Dans la même zone de contact, il est prévu des pièces d'insertion 6, qui sont réalisées à la manière de pièces crimp, initialement avec une section transversale en U avec des branches aux extrémités dentées.

Les deux rangées parallèles de dents 7 des pièces d'insertion 6 sont d'abord enfoncées à travers l'élément de raccordement 1, de façon telle que la feuille de support 2 soit entièrement traversée de part et d'autre de chaque piste conductrice 3 (côté gauche), et ensuite rabattues latéralement l'une vers l'autre au moyen d'un outil approprié (côté droit). Elles pourraient également traverser ou toucher les pistes conductrices elles-mêmes. Cela n'est cependant pas nécessaire au point de vue fonctionnel, parce que - contrairement aux sertissages crimp conventionnels - on n'a pas besoin d'un contact électrique direct entre la pièce d'insertion et la piste conductrice. La direction de pressage est orientée d'une façon telle que les dents 7 sortent sur le côté de la zone de contact et soient rabattues vers la face de contact respective 5. De ce fait, cette dernière est fermement enveloppée par la pièce d'insertion respective 6 entre les dents rabattues 7 de celle-ci, les branches et l'âme 8 de la section transversale en U initiale. L'âme 8 est placée, avec une face extérieure libre, sur la surface de la couche supérieure 2.1 de la feuille de support 2 située à l'opposé des faces de contact 5. Ceci aussi est la plupart du temps différent dans les sertissages crimp usuels - si les dents ne traversent pas elles-mêmes la piste conductrice, on y presse l'âme plus ou moins à plat sur une portion dénudée de la piste conductrice respective, pour assurer un passage du courant aussi bon que possible.

La longueur des dents 7 des pièces d'insertion 6 doit être adaptée selon les besoins. Pour des attaches crimp usuelles, elles sont plus longues que dans cette représentation. Les pointes des dents peuvent se chevaucher après le rabattement, en regardant dans la direction longitudinale de la piste conductrice. Dans un tel cas, il peut être avantageux que les deux rangées de dents soient décalées l'une par rapport à l'autre dans la direction longitudinale.

Dans une étape ultérieure, on a à présent formé un dépôt de soudure 9, après le rabattement des dents 7, sur le côté denté de la pièce d'insertion 6, d'une façon telle que la soudure mouille non seulement les dents 7, mais aussi la face de contact 5. La quantité de soudure utilisée est suffisamment grande pour s'élever encore légèrement au-dessus des dents 7. De cette manière, on assure que la soudure fondue établit un contact électrique direct entre la face de contact 5 et une face de raccordement associée à celle-ci (voir Fig. 3).

En ce qui concerne les dimensions effectives de ces composants, il convient de remarquer que les pistes conductrices ont, dans un exemple de réalisation donné, une largeur d'environ 1,5 mm et une épaisseur d'environ 0,1 mm, tandis que la longueur des pièces d'insertion 6, qui sont constituées par des morceaux de tôle d'environ 0,2 mm d'épaisseur, vaut environ 3 - 5 mm. Les dents doivent bien entendu être suffisamment longues, pour traverser la feuille de support et pouvoir encore être recourbées.

La Figure 2 montre une autre variante du dépôt de soudure 9, suivant laquelle un morceau de fil de soudage tendre 10 est à nouveau coincé à froid au moyen d'un outil approprié entre les dents rabattues 7 de la pièce d'insertion 6, d'une façon telle que d'une part il touche la face de contact 5 et que d'autre part il s'élève encore légèrement au-dessus des dents 7. Cette variante présente l'avantage que la zone de contact 4 ne doit pas être déjà chauffée lors de la formation du dépôt. De façon connue, le fil de soudage peut, à la différence de la représentation, avoir une section tubulaire et être combiné avec un cordon de fondant disposé à l'intérieur, qui facilite le soudage ultérieur.

Dans la Figure 3 on montre, à titre de cas d'application préféré esquissé de façon simplifiée pour l'élément de raccordement décrit ici, un assemblage soudé terminé entre une face de contact individuelle 5 et une face de raccordement 11 qui lui est associée. Cette dernière est prévue sur une vitre de fenêtre 12 en verre ou en matière plastique et raccordée par exemple à des éléments d'antenne ou des éléments chauffants 13 uniquement indiqués ici. La face de raccordement 11 peut de façon connue, comme aussi les éléments électriques qui suivent, être avantageusement fabriquée à partir d'une pâte d'argent conductrice déposée par sérigraphie et cuite. Si nécessaire, elle peut même aussi être pré-étamée.

La figure 3 montre en instantané l'instant de la fusion complète du dépôt de soudure 9 sous la pièce d'insertion 6, sur l'âme de laquelle est encore appliquée la pointe d'un outil de soudage 14 indiquée seulement en traits mixtes. Visiblement, la chaleur est transférée de l'outil de soudage 14 au point de soudage proprement dit essentiellement par la matière de la pièce d'insertion métallique 6, ce qui est cependant sensiblement plus rapide que le soudage actuel à travers la couche supérieure 2.1 de la feuille. En même temps, ses dents rabattues 7 forment une pièce d'écartement entre le côté inférieur de l'élément de raccordement dans la zone de contact et le côté supérieur de la vitre de fenêtre 12, respectivement de la face de raccordement 11, sur laquelle elles s'appliquent. On assure ainsi une épaisseur de la soudure définie dans des limites étroites. Celle-ci peut cependant encore s'écouler latéralement, lors de la fusion, à travers les fentes entre les dents 7 et ainsi élargir la base de l'assemblage soudé par rapport à la distance entre les pointes des dents.

Au lieu de l'outil 14, il peut être prévu un apport de chaleur sans contact par rayonnement (par exemple laser), la pression d'application sur le point de soudage devant alors être exercée d'une autre manière appropriée.

Bien entendu, une telle zone de contact peut, à la différence de la présente représentation simplifiée, comporter un nombre pratiquement quelconque de paires de faces de contact et de raccordement.

Dans la Figure 4, on a représenté en l'agrandissant encore davantage une variante de l'élément de raccordement, qui comprend un câble 15 dénudé à l'extrémité en guise de conducteur électrique. A la différence de la figure 3, la coupe est faite ici dans le sens longitudinal du conducteur. La feuille de support 2 peut n'avoir qu'une seule couche dans la zone de raccordement du câble 15, comme cela est représenté, ou correspondre à la réalisation suivant les autres figures. Comme face de contact 5 du conducteur, il faut considérer dans cette variante l'extrémité du câble 15 débarrassée de son isolant 16. Au moyen de la pièce d'insertion 6, qui est réalisée conformément aux figures 1 à 3, l'extrémité dénudée du câble est assemblée mécaniquement à la feuille de support 2 et au dépôt de soudure associé 9. Cette vue, qui est tournée de 90° par rapport à celle de la figure 3, montre comment les dents 7 de la pièce d'insertion 6 ont déformé plastiquement le dépôt de soudure constitué à nouveau par une portion d'un fil de soudage. A la fusion du dépôt de soudure 9, sa matière raccordera de façon sûre la face de raccordement 11 et la face de contact 5 comme dans la figure 3.

Finalement, il convient encore de signaler explicitement que le dépôt de soudure pourrait aussi, à la différence des représentations illustrées ici, être en cas de besoin formé sur l'arrière, c'est-à-dire sur l'âme 8 des pièces d'insertion 6, si un raccordement électrique sûr peut en même temps être garanti entre le conducteur électrique et la pièce d'insertion. Naturellement, celui-ci pourrait même aussi être serré entre l'âme et la feuille de support. Si le dépôt de soudure n'est, également dans cette variante, fixé que mécaniquement entre la feuille de support 2 et l'âme 8, il faut naturellement prévoir dans cette dernière des creux à travers lesquels la soudure fondue peut s'écouler vers la face de raccordement.

## Revendications

1. Elément de raccordement électrique soudable comportant une mince feuille de support (2) et au moins un conducteur métallique (3; 15) présentant au moins une face de contact (5) qui est pourvue d'un dépôt de soudure (9) et qui peut être assemblée par soudage de ce dépôt de soudure à une face de raccordement (11) d'un autre composant (12, 13) qui lui est associée, **caractérisé en ce qu'**une pièce d'insertion (6) pourvue du dépôt de soudure (9) et traversant l'élément de raccordement (1) est solidement assemblée à la feuille de support (2) dans la région de la face de contact (5).

2. Elément de raccordement suivant la revendication 1, **caractérisé en ce que** le conducteur a la forme d'une piste conductrice (3) assemblée à plat à la feuille de support (2).

3. Elément de raccordement suivant la revendication 1, **caractérisé en ce que** le conducteur a la forme d'un câble (15) assemblé au moins mécaniquement à la feuille de support (2).

4. Elément de raccordement suivant l'une quelconque des revendications précédentes, **caractérisé en ce que** le dépôt de soudure (9) est produit par une quantité de soudure soudée avec la pièce d'insertion (6).

5. Elément de raccordement suivant l'une quelconque des revendications précédentes, **caractérisé en ce que** le dépôt de soudure (9, 10) est fixé mécaniquement à la feuille de support (2) au moyen de la pièce d'insertion (6).

6. Elément de raccordement suivant l'une quelconque des revendications précédentes, **caractérisé en ce que** le dépôt de soudure (9) est soudable directement à la face de contact (5) du conducteur (3; 15).

7. Elément de raccordement suivant l'une quelconque des revendications précédentes, **caractérisé en ce que** la pièce d'insertion (6) présente, avant l'assemblage avec l'élément de raccordement (1), une section transversale sensiblement en forme de U avec une âme (8) et des branches ayant des extrémités libres dentées, dont les dents (7) sont pressées à travers l'élément de raccordement (1) et ensuite rabattues latéralement.

8. Elément de raccordement suivant la revendication 7, **caractérisé en ce que** le dépôt de soudure (9) est formé en coinçant un morceau de fil de soudage tendre (10) entre les dents (7) de la pièce d'insertion (6) d'une part et la feuille de support (2) ou la face de contact (5) d'autre part.

9. Elément de raccordement suivant la revendication 7, **caractérisé en ce que** le dépôt de soudure est formé en coinçant un morceau de fil de soudage tendre entre l'âme de la pièce d'insertion d'une part et la feuille de support ou la face de contact d'autre part.

10. Elément de raccordement suivant la revendication 9, **caractérisé en ce que** l'âme est pourvue de creux, à travers lesquels la soudure fondue peut sortir en direction de la face de raccordement.

11. Elément de raccordement suivant l'une quelconque des revendications précédentes, **caractérisé en ce que** la zone de contact (4) comprenant la face de contact (5) est pourvue d'une portion adhésive.

12. Vitre de fenêtre (12), en particulier vitre de verre, avec au moins un élément de raccordement soudable (1) suivant l'une quelconque des revendications précédentes, qui est pourvue sur au moins une de ses surfaces d'une face de raccordement (11) pour des éléments électriques, qui est soudée à une face de contact (5) de l'élément de raccordement (1) à l'aide du dépôt de soudure (9).

13. Vitre de fenêtre suivant la revendication 12, **caractérisée en ce qu'**il est en outre prévu, dans la zone de contact (4) du point de soudage, un assemblage collé entre l'élément de raccordement (1) et la surface de la vitre de fenêtre (12).

14. Vitre de fenêtre suivant la revendication 12 ou 13, **caractérisé en ce que** la surface de la vitre de fenêtre forme la face intérieure d'une vitre feuilletée.

## Claims

1. Solderable electrical connection element, comprising a thin support sheet (2) and at least one metal conductor (3; 15) having at least one contact face (5) which is provided with a solder deposit (9) and which can be joined by soldering this solder deposit to a connection face (11) of another component (12, 13) with which it is associated, **characterized in that** an insertion piece (6) provided with the solder deposit (9) and passing through the connection element (1) is securely joined to the support sheet (2) in the region of the contact face (5).

2. Connection element according to Claim 1, **characterized in that** the conductor has the shape of a conducting track (3) joined flat to the support sheet (2).

3. Connection element according to Claim 1, **characterized in that** the conductor has the shape of a cable (15) at least mechanically joined to the support sheet (2).

4. Connection element according to any one of the preceding claims, **characterized in that** the solder deposit (9) is produced by a quantity of solder soldered to the insertion piece (6).

5. Connection element according to any one of the preceding claims, **characterized in that** the solder deposit (9, 10) is mechanically fastened to the support sheet (2) by means of the insertion piece (6).

6. Connection element according to any one of the preceding claims, **characterized in that** the solder deposit (9) can be soldered directly to the contact face (5) of the conductor (3; 15).

7. Connection element according to any one of the preceding claims, **characterized in that** the insertion piece (6) has, before it is joined to the connection element (1), an approximately U-shaped cross section with a core (8) and branches having toothed free ends, the teeth (7) of which are pressed through the connection element (1) and then turned up laterally.

8. Connection element according to Claim 7, **characterized in that** the solder deposit (9) is formed by jamming a length of soft solder wire (10) between, on the one hand, the teeth (7) of the insertion piece (6) and, on the other hand, the support sheet (2) or the contact face (5).

9. Connection element according to Claim 7, **characterized in that** the solder deposit is formed by jamming a length of soft solder wire between, on the one hand, the core of the insertion piece and, on the other hand, the support sheet or the contact face.

10. Connection element according to Claim 9, **characterized in that** the core is provided with cavities through which the molten solder can flow out towards the connection face.

11. Connection element according to any one of the preceding claims, **characterized in that** the contact zone (4) comprising the contact face (5) is provided with an adhesive portion.

12. Window pane (12), particularly a glass pane, with at least one solderable connection element (1) according to any one of the preceding claims, which window pane is provided on at least one of its surfaces with a connection face (11) for electrical elements, which is soldered to a contact face (5) of the connection element (1) with the aid of the solder deposit (9).

13. Window pane according to Claim 12, **characterized in that**, in the contact zone (4) of the soldering point, provision is also made for there to be an adhesively bonded joint between the connection element (1) and the surface of the window pane (12).

14. Window pane according to Claim 12 or 13, **characterized in that** the surface of the window pane forms the inner face of a laminated pane.

## Patentansprüche

1. Lötbares elektrisches Anschlusselement mit einer dünnen Trägerfolie (2), mindestens einem metallischen Leiter (3; 15) und mindestens einer Kontaktfläche (5) dieses Leiters, welche mit einem Lotdepot (9) versehen und durch Verlöten dieses Lotdepots mit einer ihr zugeordneten Anschlussfläche (11) eines anderen Bauteils (12, 13) verbindbar ist, **dadurch gekennzeichnet, dass** im Bereich der Kontaktfläche (5) ein das Anschlusselement (1) durchdringendes, mit dem Lotdepot (9) versehenes Einsatzstück (6) fest mit der Trägerfolie (2) verbunden ist.

2. Anschlusselement nach Anspruch 1, **dadurch gekennzeichnet, dass** der Leiter als mit der Trägerfolie (2) flächig verbundene Leiterbahn (3) ausgeführt ist.

3. Anschlusselement nach Anspruch 1, **dadurch gekennzeichnet, dass** der Leiter als mit der Trägerfolie (2) zumindest mechanisch verbundenes Kabel (15) ausgeführt ist.

4. Anschlusselement nach einem der vorstehenden Ansprüche, **dadurch gekennzeichnet, dass** das Lotdepot (9) durch eine mit dem Einsatzstück (6) verlötete Lotmenge hergestellt ist.

5. Anschlusselement nach einem der vorstehenden Ansprüche, **dadurch gekennzeichnet, dass** das Lotdepot (9, 10) mittels des Einsatzstücks (6) mechanisch an der Trägerfolie (2) fixiert ist.

6. Anschlusselement nach einem der vorstehenden Ansprüche, **dadurch gekennzeichnet, dass** das Lotdepot (9) direkt mit der Kontaktfläche (5) des Leiters (3; 15) verlötbar ist.

7. Anschlusselement nach einem der vorstehenden Ansprüche, **dadurch gekennzeichnet, dass** das Einsatzstück (6) vor dem Verbinden mit dem Anschlusselement (1) im Querschnitt etwa u-förmig mit einem Steg (8) und gezahnten freien Schenkelenden ausgeführt ist, dessen Zähne (7) durch das Anschlusselement (1) gepresst und anschließend seitlich umgeschlagen sind.

8. Anschlusselement nach Anspruch 7, **dadurch gekennzeichnet, dass** das Lotdepot (9) durch Einklemmen eines Stücks weichen Lotdrahts (10) zwischen den Zähnen (7) des Einsatzstücks (6) einerseits und der Trägerfolie (2) oder der Kontaktfläche (5) andererseits angelegt ist.

9. Anschlusselement nach Anspruch 7, **dadurch gekennzeichnet, dass** das Lotdepot durch Einklemmen eines Stücks weichen Lotdrahts zwischen dem Steg des Einsatzstücks einerseits und der Trägerfolie oder der Kontaktfläche andererseits angelegt ist.

10. Anschlusselement nach Anspruch 9, **dadurch gekennzeichnet, dass** der Steg mit Ausnehmungen versehen ist, durch welche aufschmelzendes Lot zu der Anschlussfläche hin austreten kann.

11. Anschlusselement nach einem der vorstehenden Ansprüche, **dadurch gekennzeichnet, dass** der die Kontaktfläche (5) umfassende Kontaktbereich (4) mit einem Klebeabschnitt versehen ist.

12. Fensterscheibe (12), insbesondere Glasscheibe, mit mindestens einem lötbaren Anschlusselement (1) nach einem der vorstehenden Ansprüche, welche auf mindestens einer ihrer Oberflächen mit einer Anschlussfläche (11) für elektrische Elemente versehen ist, die mit Hilfe des Lotdepots (9) mit einer Kontaktfläche (5) des Anschlusselements (1) verlötet ist.

13. Fensterscheibe nach Anspruch 12, **dadurch gekennzeichnet, dass** im Kontaktbereich (4) der Lötstelle ferner eine Klebeverbindung zwischen dem Anschlusselement (1) und der Oberfläche der Fensterscheibe (12) vorgesehen ist.

14. Fensterscheibe nach Anspruch 12 oder 13, **dadurch gekennzeichnet, dass** die Oberfläche der Fensterscheibe eine Innenfläche einer Verbundscheibe bildet.
